# EUROPEAN PATENT APPLICATION

(11) **EP 3 508 896 A1**
(43) Date of publication of application: **10.07.2019**
(21) Application number: 17846294.1
(22) Date of filing: 24.08.2017
(51) Int. Cl.: G02B 6/02, H01S 3/067

(54) **CHIRPED FIBER GRATING ELEMENT AND FIBER LASER**

(30) Priority: 30.08.2016 JP 2016168270
(71) Applicant: Fujikura Ltd., Tokyo 135-8512 (JP)
(72) Inventor: SAKAMOTO, Shinichi, Sakura-shi Chiba 285-8550 (JP)
(74) Representative: Cabinet Plasseraud
(86) International application number: PCT/JP2017/030366
(87) International publication number: WO 2018/043289

(57) **Abstract**

The present invention provides a chirped fiber grating element in which an amount of heat generated in the vicinity of an incident end surface is small. The chirped fiber grating element is configured such that: a pitch Λi of a grating (11a) increases with increasing distance from one end surface (1A); and a refractive index difference Δni of the grating (11a) increases with increasing distance from the end surface (1A).

## Description

### Technical Field

The present invention relates to a chirped fiber grating element which is obtained by writing, into a core of an optical fiber, a grating whose pitch gradually becomes longer with increasing distance from one end surface. The present invention also relates to a fiber laser which includes the chirped fiber grating element.

### Background Art

A fiber laser is widely used as a laser oscillator in the fields of optical machining and optical communication. The fiber laser is configured such that in order to form a cavity which includes an amplifying optical fiber to a core of which a rare earth element is added, a fiber Bragg grating element which serves as a mirror is connected to one end of the amplifying optical fiber, and a fiber Bragg grating element which serves as a half mirror is connected to the other end of the amplifying optical fiber. A fiber Bragg grating element is an element which is obtained by writing a grating having a constant pitch (A) into an optical fiber, and has a function of selectively reflecting light that has a wavelength of 2nA (n is a natural number).

The above-described fiber laser, when adjusted to have an increased output, becomes more likely to undergo a nonlinear optical effect such as spectral hole burning or stimulated Raman scattering. In order to avoid this, it is necessary to widen a lasing wavelength band of the fiber laser. In such a case, instead of a general fiber Bragg grating which is a regular-pitched grating written in a core, a chirped fiber grating element, which has a core into which a grating is written such that a pitch of the grating gradually become longer with increasing distance from one end surface, is used as a mirror and a half mirror. This is because the chirped fiber grating element has a reflection band wider than that of the general fiber Bragg grating.

The above-described chirped fiber grating element is disclosed in Patent Literature 1 (corresponding to "fiber Bragg grating element" of Patent Literature 1). According to Patent Literature 1, writing the same grating into a core and into a clad allows achieving a wider reflection band as well as an increase in amount of blocked light.

### Citation List

### [Patent Literature]

[Patent Literature 1]
Japanese Patent Application Publication, Tokukai, No. 2008-282044 A (Publication Date: November 20, 2008)

### Summary of Invention

### Technical Problem

However, conventional chirped fiber grating elements have the following problem. That is, a conventional chirped fiber grating element has a densely formed grating, and light enters the core from an end surface of the chirped fiber grating element on a side where a light energy density is higher than the other side due to multiple interference between incident light and reflected light. This results in a large amount of heat generation in the vicinity of the incident end surface, and a resultant decrease in reliability. This problem is caused for the following reason.

That is, in order to manufacture a chirped fiber grating element, it is necessary to produce first an optical fiber to a core of which an element having photosensitivity (e.g., germanium) is added and then irradiate the optical fiber with ultraviolet light so as to write a grating into the optical fiber (regions which are irradiated with the ultraviolet light become high refractive index regions constituting the grating). At this time, defects are formed inside the regions irradiated with the ultraviolet light (i.e., inside the high refractive index regions constituting the grating). As such, when light enters the grating of the chirped fiber grating element, part of the light is converted into heat due to a defect included in each of the high refractive index regions constituting the grating. Particularly, in the chirped fiber grating element, the grating is formed densely in the vicinity of the incident end surface, at which light energy density is increased due to multiple interference between incident light and reflected light. This tends to increase the amount of heat generation in the vicinity of the incident end surface.

The present invention is accomplished in view of the foregoing problem. An object of the present invention is to provide a chirped fiber grating element which has a smaller amount of heat generation in the vicinity of an incident end surface and a higher level of reliability, as compared with a conventional chirped fiber grating element.

### Solution to Problem

In order to attain the object, a chirped fiber grating element in accordance with the present invention is a chirped fiber grating element including: a core which has a refractive index of n0 and into which a grating consisting of high refractive index regions are written, each of the high refractive index regions having a refractive index of ni (ni > n0), a pitch Λi of the grating increasing with increasing distance from one end surface of the chirped fiber grating element, a refractive index difference Δni = ni-n0 of the grating increasing with increasing distance from the one end surface of the chirped fiber grating element.

Further, in order to attain the object, the chirped fiber grating element in accordance with the present invention is a chirped fiber grating element including: a core which has a refractive index of n0 and into which a grating consisting of high refractive index regions are written, each of the high refractive index regions having a refractive index of ni (ni > n0), a pitch Ai of the grating increasing with increasing distance from one end surface of the chirped fiber grating element, a thickness Di of the each of the high refractive index regions increasing with increasing distance from the one end surface of the chirped fiber grating element.

### Advantageous Effects of Invention

The present invention enables providing a chirped fiber grating element in which an amount of heat generated in the vicinity of an incident end surface is smaller as compared with a conventional chirped fiber grating element. This allows the chirped fiber grating element to ensure a higher level of reliability as compared with the conventional chirped fiber grating element.

### Brief Description of Drawings

Fig. 1 is a vertical cross-sectional view and a lateral cross-sectional view of a chirped fiber grating element in accordance with an embodiment.
Fig. 2 is a graph showing a refractive index distribution of a core of the chirped fiber grating element illustrated in Fig. 1.
Fig. 3 is a graph showing a distribution of powers of component waves which have respective wavelengths of 1062.5 nm, 1063.5 nm, 1064.5 nm, and 1065.5 nm and are included in light which has entered the core of the chirped fiber grating element illustrated in Fig. 1.
Fig. 4 is a graph showing a quadratic function Λ1(z), a quadratic function A2(z), and a linear function Λ0(z) which define pitches of gratings of respective chirped fiber grating elements in accordance with Example 1, Example 2, and Comparative Example.
Fig. 5 is a graph showing a transmission spectrum of each of the chirped fiber grating elements in accordance with Example 1, Example 2, and Comparative Example.
Fig. 6 is a graph showing a distribution of amounts of heat generation of each of the chirped fiber grating elements in accordance with Example 2 and Comparative Example.
Fig. 7 is a vertical cross-sectional view and a lateral cross-sectional view of a chirped fiber grating element in accordance with Modified Example.
Fig. 8 is a schematic view illustrating passages of light which has entered the chirped fiber grating element illustrated in Fig. 1.

### Description of Embodiments

### [Configuration of chirped fiber grating element]

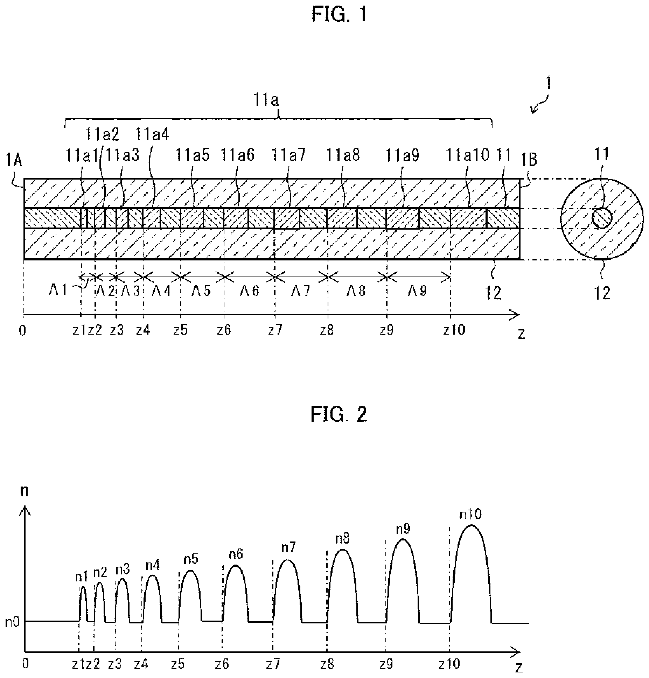

The following description will discuss, with reference to Fig. 1, a configuration of a chirped fiber grating element 1 in accordance with an embodiment of the present invention. Fig. 1 is a vertical cross-sectional view (on the left hand side) and a lateral cross-sectional view (on the right hand side) of the chirped fiber grating element 1.

As illustrated in Fig. 1, the chirped fiber grating element 1 is an optical fiber-type element including: a core 11 which is in the shape of a circular rod; and a clad 12 which is in the shape of a circular tube and surrounds the core 11. The clad 12 has a refractive index n_{clad} lower that a refractive index n_{core} of the core 11. Light which has entered the core 11 via one end surface 1A propagates through the core 11 and exits the core 11 via the other end surface 1B. Note that the chirped fiber grating element 1 may include a coating (not illustrated) which is in the shape of a circular tube and surrounds the clad 12.

As illustrated in Fig. 1, a grating 11a, which is made up of a plurality of high refractive index regions 11a1 through 11a10 arranged along a central axis of the core 11 of the chirped fiber grating element 1, is written into the core 11. Each high refractive index region 11ai (i = 1, 2, ..., 10) is a region which is in the shape of a circular rod and has a refractive index higher than a refractive index (a refractive index of the regions other than the high refractive index regions 11a1 through 11a10) n0 of a base material of the core 11. The refractive index of each high refractive index region 11ai will be described later with reference to another drawing.

As illustrated in Fig. 1, pitches Λ1 through A9 of the grating 11a become longer with increasing distance from the end surface 1A. Note here that each Ai is an amount defined by Λi = zi+1 - zi where zi is a distance from the end surface 1A to a center of each high refractive index region 11ai. Ai represents an interval between respective canters of two adjacent high refractive index regions 11ai and 11ai+1. In a conventional chirped fiber grating element, pitches Λ1 through A9 of a grating 11a linearly become longer with increasing distance from the end surface 1A. More precisely, a function Λ(z) which satisfies Λ(zi) = Λi is obtained by a linear function of z: Λ(z) = α₀+α₁z (each of α₀ and α₁ is a constant). Meanwhile, in the chirped fiber grating element 1 in accordance with the present embodiment, the pitches Λ1 through Λ9 of the grating 11a quadratically become longer with increasing distance from the end surface 1A. More precisely, a function Λ(z) which satisfies A(zi) = Ai is obtained by a quadratic function of z: Λ(z) = α₀+α₁z+α₂z² (each of α₀, α₁, and α₂ is a constant). Note that a thickness Di of the high refractive index region 11ai is determined so that a ratio Di/Λi is constant (in the example illustrated in Fig. 1, 0.5).

A wavelength band of light reflected by the chirped fiber grating element 1 is wider than that of light reflected by a general fiber Bragg grating element into which a grating with a constant pitch (Λ) is written. This is because the grating of the general fiber Bragg grating element selectively reflects light having a wavelength of 2nΛ (n is an integer), whereas the grating 11a of the chirped fiber grating element 1 selectively reflects light having a wavelength of not less than 2nΛ1 and not more than 2nΛ9.

Note that the grating 11a can be written in the chirped fiber grating element 1 by a method similar to that employed for writing a grating into the general fiber Bragg grating element. That is, an optical fiber, to a core 11 of which an element (e.g., germanium) having photosensitivity (sensitivity to ultraviolet light) is added, is produced first and then regions of the optical fiber in which regions the high refractive index regions 11a1 through 11a10 are to be formed are selectively irradiated with ultraviolet light. Note here that the refractive index of each high refractive index region 11ai (i) increases as an amount of ultraviolet light applied to the region in which the high refractive index region 11ai is to be formed is increased and (ii) decreases as the amount of the ultraviolet light applied to the region in which the high refractive index region 11ai is to be formed is decreased. As such, in order for the refractive index of each high refractive index region 11ai to be a target refractive index, an intensity of the ultraviolet light applied to the region and time during which the region is irradiated with the ultraviolet light should be adjusted so that an amount of the ultraviolet light applied to the region in which the high refractive index region 11ai is to be formed is adjusted in accordance with the target refractive index.

### [Refractive index distribution of core]

The following description will discuss, with reference to Fig. 2, a refractive index distribution of the core 11 of the chirped fiber grating element 1. Fig. 2 is a graph showing the refractive index distribution of the core 11. In the graph of Fig. 2, the horizontal axis represents a distance z from the one end surface 1A of the chirped fiber grating element 1 and the vertical axis represents the refractive index n_{core} of the core.

As shown in Fig. 2, the grating 11a has a refractive index difference Δni which increases with increasing distance from the one end surface 1A of the chirped fiber grating element 1. Note here that the refractive index difference Δni is an amount defined by Δni = ni-n0 where ni is the maximum refractive index in each high refractive index region 11ai and n0 is the refractive index of the base material of the core 11. In the conventional chirped fiber grating element, refractive index differences n1 through n10 of the grating 11a are constant. Meanwhile, in the chirped fiber grating element 1 in accordance with the present embodiment, refractive index differences n1 through n10 of the grating 11a are linearly increased with increasing distance from the end surface 1A. More precisely, a function Δn(z) which satisfies Δn(zi) = Δi is obtained by a linear function of z: Δn(z) = β₀+β₁z (each of β₀ and β₁ is a constant).

Employing the above-described refractive index distribution brings about an advantageous effect as described below. For simplicity, the following description will consider a case in which light in a wavelength band of not less than λ1 = 2Λ1 and not more than λ9 = 2Λ9 is caused to enter the core 11 of the chirped fiber grating element 1 from the one end surface 1A.

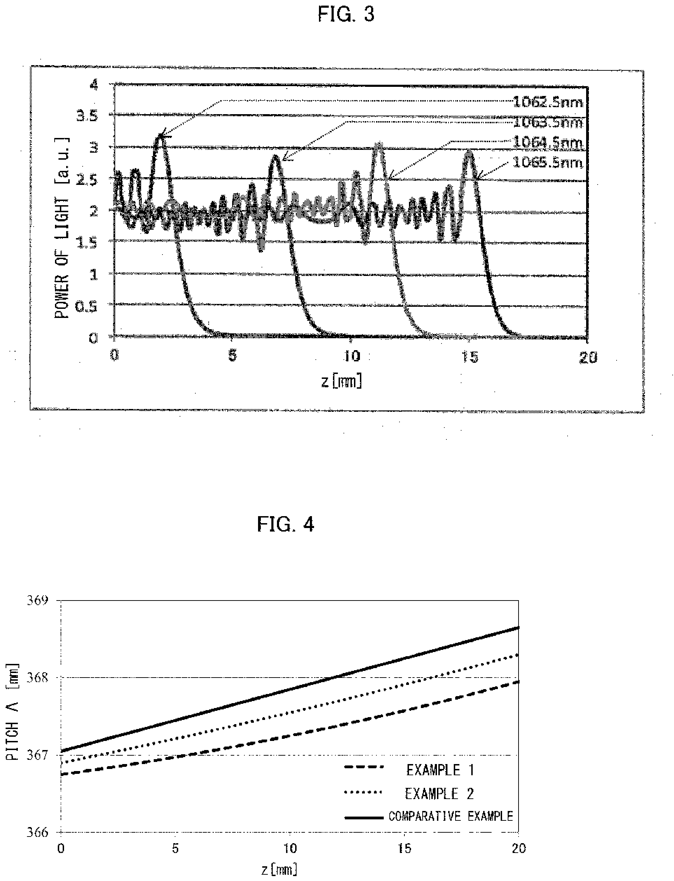

The chirped fiber grating element 1 employs a configuration in which the pitches Λ1 through Λ9 of the grating 11a become longer with increasing distance from the end surface 1A. Accordingly, light which has entered the core 11 from the end surface 1A is reflected such that a component wave having a shorter wavelength is reflected in a region that is located closer to the end surface 1A. In other words, a component wave having a longer wavelength reaches a region that is located farther from the end surface 1A. For example, component waves having respective wavelengths of 1062.5 nm, 1063.5 nm, 1064.5 nm, and 1065.5 nm, which component waves are included in light that has entered the core 11 from the end surface 1A, have powers whose distribution is as shown in Fig. 3. Thus, a power density of light in the core 11 is maximized at the end surface 1A and decreases with increasing distance from end surface 1A.

The conventional chirped fiber grating element employs a configuration in which the refractive index differences Δn1 through Δn10 of the grating 11a are constant. Accordingly, an amount of heat generation is maximized in the high refractive index region 11a1, which is located the closest to the end surface 1A, among the high refractive index regions 11a1 through 11a10 and decreases with increasing distance from end surface 1A. Meanwhile, the chirped fiber grating element 1 in accordance with the present embodiment employs a configuration in which the refractive index differences Δn1 through Δn10 of the grating 11a are linearly increased with increasing distance from the end surface 1A (linearly decreased toward the end surface 1A).

Accordingly, in a case where a power of light entering the core from the end surface 1A is the same between the chirped fiber grating element 1 and the conventional chirped fiber grating element, an amount of heat generation in a high refractive index region 11ai (e.g., i = 1, 2, 3) that is located close to the end surface 1A is smaller in the chirped fiber grating element 1 as compared with the conventional chirped fiber grating element. Further, an amount of heat generation in a high refractive index region 11ai (e.g., i = 10, 9, 8) that is located far from the end surface 1A is larger in the chirped fiber grating element 1 as compared with the conventional chirped fiber grating element. This phenomenon is caused for the following reason. An amount of heat generated in each high refractive index region 11ai in a case where light having a unit power density enters the each high refractive index region 11ai is correlated to the number of defects included in the each high refractive index region 11ai (defects that are formed during ultraviolet light irradiation for creating the refractive index difference Δni). A high refractive index region 11ai that is located close to the end surface 1A is irradiated with a relatively small amount of ultraviolet light, and includes a relatively small number of defects, accordingly. A high refractive index region 11ai that is located far from the end surface 1A is irradiated with a relatively large amount of ultraviolet light, and includes a relatively large number of defects, accordingly. This is the cause of the above-described phenomenon.

Accordingly, a distribution of amounts of heat generation of the chirped fiber grating element 1 in accordance with the present embodiment is more averaged (more uniform) than that of the conventional chirped fiber grating element. This allows lowering a temperature of the high refractive index region 11ai located close to the end surface 1A (especially the high refractive index region 11a1 which is located the closest to the end surface 1A) of the chirped fiber grating element 1, as compared with the conventional chirped fiber grating element. As a result, the chirped fiber grating element 1 can ensure a higher level of reliability than that of the conventional chirped fiber grating element.

### [Examples]

Firstly, a chirped fiber grating element 1 having a grating 11a with a pitch Λi defined by a quadratic function Λ1(z) shown in a graph of Fig. 4 was fabricated as Example 1. The chirped fiber grating element 1 in accordance with Example 1 includes a core 11, which has a diameter of 20 µm and an effective refractive index of 1.45 with respect to light propagating through the core 11. The grating 11a is constituted by high refractive index regions 11ai, the number of which is approximately 55000. A refractive index difference Δni of the grating 11a of the chirped fiber grating element 1 in accordance with Example 1 was defined by a linear function n(z) satisfying Δn(zout)/Δn(zin) = 1.16. Note here that zin is a distance from an incident end surface 1A of the chirped fiber grating element 1 to a high refractive index region 11a1 that is located the closest to the incident end surface 1A, and zout is a distance from the incident end surface 1A to a high refractive index region 11aN (N is the number of high refractive index regions 11ai constituting the grating 11a) that is located the closest to an exit end surface 1B.

Further, a chirped fiber grating element 1 having a grating 11a with a pitch Ai defined by a quadratic function A2(z) shown in the graph of Fig. 4 was fabricated as Example 2. The chirped fiber grating element 1 in accordance with Example 2 includes a core 11, which has a diameter of 20 µm and an effective refractive index of 1.45 with respect to light propagating through the core 11. The grating 11a is constituted by high refractive index regions 11ai, the number of which is approximately 55000. A refractive index difference Δni of the grating 11a of the chirped fiber grating element 1 in accordance with Example 2 was defined by a linear function n(z) satisfying Δn(zout)/Δn(zin) = 1.29.

Further, a chirped fiber grating element having a grating with a pitch Λi defined by a linear function Λ0(z) shown in the graph of Fig. 4 was fabricated as Comparative Example. The chirped fiber grating element in accordance with Comparative Example includes a core, which has a diameter of 20 µm and an effective refractive index of 1.45 with respect to light propagating through the core. The grating is constituted by high refractive index regions, the number of which is approximately 55000. A refractive index difference Δni of the grating of the chirped fiber grating element in accordance with Comparative Example was constant.

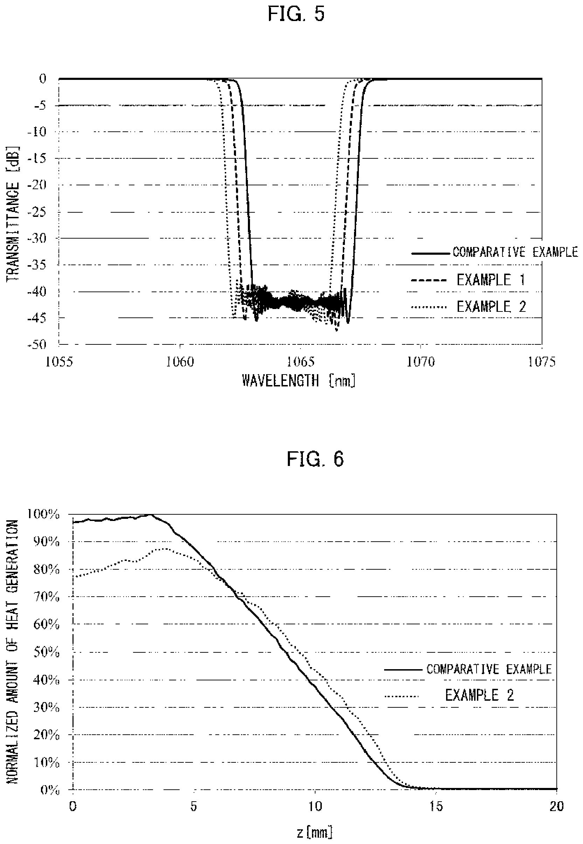

Fig. 5 is a graph showing a transmission spectrum of each of the chirped fiber grating element 1 in accordance with Example 1, the chirped fiber grating element 1 in accordance with Example 2, and the chirped fiber grating element in accordance with Comparative Example.

According to the graph of Fig. 5, the chirped fiber grating element 1 in accordance with Example 1 and the chirped fiber grating element 1 in accordance with Example 2 each have a transmission spectrum equivalent to that of the chirped fiber grating element in accordance with Comparative Example. This shows that no degradation in optical characteristic is caused by employment of a configuration in which the pitch Λi of the grating 11a is quadratically increased and the refractive index difference Δni of the grating 11a is linearly increased.

Fig. 6 is a graph showing a distribution of amounts of heat generation of each of the chirped fiber grating element 1 in accordance with Example 2 and the chirped fiber grating element in accordance with Comparative Example. The amounts of heat generation of the chirped fiber grating element in accordance with Comparative Example shown in Fig. 6 are normalized such that the maximum amount of heat generation is defined as 100%. The amounts of heat generation of the chirped fiber grating element 1 in accordance with Example 2 shown in Fig. 6 are normalized such that a total amount of heat generation coincides with a total amount of heat generation of the chirped fiber grating element in accordance with Comparative Example.

According to the graph of Fig. 6, as compared with the chirped fiber grating element in accordance with Comparative Example, the chirped fiber grating element 1 in accordance with Example 2 has a smaller amount of heat generation in a region located close to the end surface A. As a result, the maximum amount of heat generation of the chirped fiber grating element 1 in accordance with Example 2 is smaller than that of the chirped fiber grating element in accordance with Comparative Example.

### [Modified Example]

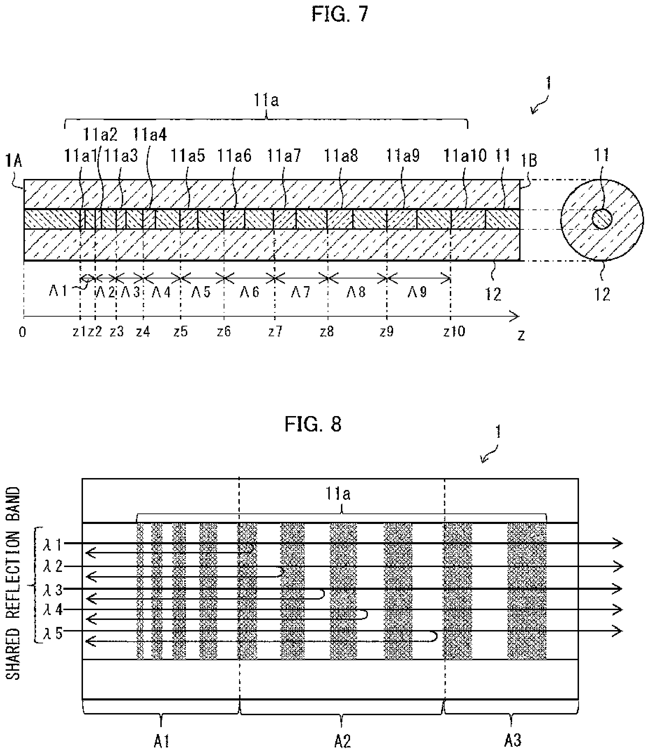

Lastly, the following description will discuss, with reference to Fig. 7, Modified Example of the chirped fiber grating element 1. Fig. 7 is a vertical cross-sectional view (on the left hand side) and a lateral cross-sectional view (on the right hand side) of a chirped fiber grating element 1 in accordance with Modified Example.

The chirped fiber grating element 1 in accordance with Modified Example employs, in place of a configuration in which a refractive index difference Δni of a high refractive index region 11ai constituting a grating 11a increases with increasing distance from an end surface 1A, a configuration in which a thickness Di of a high refractive index region 11ai constituting a grating 11a increases with increasing distance from an end surface 1A. In the example illustrated in Fig. 7, a ratio Di/Λi increases from D1/Λ1 = 0.3 to D10/Λ10 = 0.5 with increasing distance from the end surface 1A.

In this case, too, in a case where a power of light entering the core from the end surface 1A is the same between the chirped fiber grating element 1 and the conventional chirped fiber grating element, an amount of heat generation in a high refractive index region 11ai (e.g., i = 1, 2, 3) that is located close to the end surface 1A is smaller in the chirped fiber grating element 1 as compared with the conventional chirped fiber grating element. Further, an amount of heat generation in a high refractive index region 11ai (e.g., i = 10, 9, 8) that is located far from the end surface 1A is larger in the chirped fiber grating element 1 as compared with the conventional chirped fiber grating element. This phenomenon is caused for the following reason. An amount of heat generated in each high refractive index region 11ai in a case where light having a unit power density enters the each high refractive index region 11ai is correlated to the number of defects included in the each high refractive index region 11ai (defects that are formed during ultraviolet light irradiation for creating the refractive index difference Δni). A high refractive index region 11ai that is located close to the end surface 1A has a relatively small thickness D1, and includes a relatively small number of defects, accordingly. A high refractive index region 11ai that is located far from the end surface 1A has a relatively large thickness Di, and includes a relatively large number of defects, accordingly. This is the cause of the above-described phenomenon.

Accordingly, a distribution of amounts of heat generation of the chirped fiber grating element 1 in accordance with Modified Example is also more averaged (more uniform) than that of the conventional chirped fiber grating element. This allows lowering a temperature of the high refractive index region 11ai located close to the end surface 1A (especially the high refractive index region 11a1 which is located the closest to the end surface 1A) of the chirped fiber grating element 1, as compared with the conventional chirped fiber grating element. As a result, the chirped fiber grating element 1 can ensure a higher level of reliability than that of the conventional chirped fiber grating element.

### [Example application]

A fiber laser is constituted by (1) an amplifying optical fiber, (2) a mirror element connect to one end of the amplifying optical fiber, (3) a half mirror element connected to the other end of the amplifying optical fiber, (4) an excitation light source connected to the amplifying optical fiber via the mirror element, and (5) an output optical fiber connected to the amplifying optical fiber via the half mirror element. A reflection wavelength band of the mirror element and a reflection wavelength band of the half mirror element overlap with each other (this overlapped portion will hereinafter be referred to as a "shared reflection band").

The amplifying optical fiber includes a core, to which a rare earth element is added. The rare earth element absorbs excitation light from the excitation light source so as to transit to a population inversion state. Then, when signal light or spontaneous emission light enters the rare earth element which has transited to the population inversion state, induced emission of a laser beam occurs. The laser beam, which has a wavelength within the above-described shared reflection band, is recursively amplified during the course of going back and forth in a cavity between the mirror element and the half mirror element, and part of the laser beam is supplied to the output optical fiber via the half mirror element.

As the half mirror element and/or the mirror element of the above-described fiber laser, the chirped fiber grating element 1 can be used. By using the chirped fiber grating element 1, it is possible, even in a case where a lasing wavelength band of the fiber laser is widened in order to prevent occurrence of a nonlinear optical effect, to cause a laser beam to be reflected at a desired reflectance in the mirror element and the half mirror element, so that the laser beam goes back and forth in the cavity. The following are true of the chirped fiber grating element 1 to be used as the mirror element or the half mirror element.

### (1) Orientation of chirped fiber grating element 1

In a configuration A, the end surface 1A, which is one of the end surfaces of the chirped fiber grating element 1 at which one the pitch Λi of the grating 11a is shorter than at the other, is connected to the amplifying optical fiber. In a configuration B, the end surface 1A, which is one of the end surfaces of the chirped fiber grating element 1 at which one the pitch Λi of the grating 11a is longer than at the other, is connected to the amplifying optical fiber. Loss of light caused by scattering is smaller in a case where the configuration A is employed as compared with a case where the configuration B is employed.

The employment of the configuration A allows loss of light caused by scattering to be reduced for the following reason. As described above, incident light from the amplifying optical fiber has a wavelength belonging to the shared reflection band. As such, as illustrated in Fig. 8, the incident light from the amplifying optical fiber is reflected in a specific region A2 of the grating 11a such that component waves of the incident light are sequentially reflected in order of wavelength (shortest first). Accordingly, the chirped fiber grating element 1 can be divided into, in the following order from an amplifying optical fiber side, (1) a first region A1 in which a laser beam which has the lasing wavelength and has entered the chirped fiber grating element 1 from the amplifying optical fiber propagates without being reflected, (2) a second region (the same as the above described specific region) A2 in which reflection of the laser beam which has the lasing wavelength and has entered the chirped fiber grating element 1 from the amplifying fiber occurs, and (3) a third region A3 in which a laser beam, which is remaining without being reflected in the second region A2 among the laser beam which has the lasing wavelength and has entered the chirped fiber grating element 1 from the amplifying optical fiber, propagates without being reflected. Note here that the first region A1, in which both incident light and reflected light are present, has a light density higher than that of the third region A3 in which only (part of) a laser beam is present. As such, employing the configuration A allows the first region A1, which has the high light density, to have a shorter pitch Λi of the grating 11a as compared with a case in which the configuration B is employed. Also note here that loss of light caused by scattering is less likely to occur in a case of a grating having a short pitch (a light wavelength is long relative to the pitch) as compared with a grating having a long pitch (a light wavelength is short relative to the pitch). As such, employing the configuration A allows loss of light caused by scattering to be reduced as compared with a case in which the configuration B is employed.

### (2) Refractive index distribution of core

A refractive index distribution of the core 11 of the chirped fiber grating element 1 to be used as the mirror element or the half mirror element is preferably such that an average refractive index of high refractive index regions 11a1 through 11an included in the above-described second region A2 is lower than an average refractive index of all of the high refractive index regions 11a1 through 11aN.

Employing the refractive index distribution above allows the chirped fiber grating element 1 to have a temperature lower than that of a general fiber Bragg grating element (in which each high refractive index region has a refractive index equal to an average refractive index of all of the high refractive index regions 11a1 through 11aN of the chirped fiber grating element 1). This is for the following reason. That is, an average refractive index of high refractive index regions in a region in which reflected light is present is lower in the chirped fiber grating element 1, which employs the above-described refractive index distribution, than in the general fiber Bragg grating element. Accordingly, heat generated when reflected light is absorbed by the high refractive index regions is also less in the chirped fiber grating element 1, which employs the above-described refractive index distribution, than in the general fiber Bragg grating element.

A chirped fiber grating element (1) in accordance with the present embodiment is a chirped fiber grating element (1) including: a core which has a refractive index of n0 and into which a grating (11a) consisting of high refractive index regions (11ai) are written, each of the high refractive index regions (11ai) having a refractive index of ni (ni > n0), a pitch Λi of the grating (11a) increasing with increasing distance from one end surface (1A) of the chirped fiber grating element (1), a refractive index difference Δni = ni-n0 of the grating (11a) increasing with increasing distance from the one end surface (1A) of the chirped fiber grating element (1).

A chirped fiber grating element (1) in accordance with the present embodiment is a chirped fiber grating element (1) including: a core which has a refractive index of n0 and into which a grating (11a) consisting of high refractive index regions (11ai) are written, each of the high refractive index regions (11ai) having a refractive index of ni (ni > n0), a pitch Λi of the grating (11a) increasing with increasing distance from one end surface (1A) of the chirped fiber grating element (1), a thickness Di of the each of the high refractive index regions (11ai) increasing with increasing distance from the one end surface (1A) of the chirped fiber grating element (1).

The above configuration allows an amount of heat generated in the vicinity of the end surface (1A) in a case where light is caused to enter the chirped fiber grating element (1) from the one end surface (1A) to be smaller as compared with a conventional chirped fiber grating element (1) in which a refractive index difference of a grating (11a) is constant.

A chirped fiber grating element (1) in accordance with the present embodiment is preferably configured such that: the pitch Ai quadratically increases with increasing distance from the one end surface (1A) of the chirped fiber grating element (1); and the refractive index difference Δni linearly increases with increasing distance from the one end surface (1A) of the chirped fiber grating element (1).

The above configuration allows an amount of heat generated in the vicinity of the end surface (1A) in a case where light is caused to enter the chirped fiber grating element (1) from the one end surface (1A) to be smaller as compared with the conventional chirped fiber grating element (1), while maintaining an optical characteristic (in particular, transmission spectrum) to a level equivalent to that of the conventional chirped fiber grating element (1).

Note that a chirped fiber grating element (1) in accordance with the present embodiment may be used as a mirror or a half mirror of a fiber laser. That is, the present invention also encompasses, in its scope, a fiber laser which is constituted such that the chirped fiber grating element (1) is connected to both ends of an amplifying optical fiber (the chirped fiber grating element (1) connected to one end is used as a mirror and the chirped fiber grating element (1) connected to other end is used as a half mirror).

In this case, the chirped fiber grating element (1) is preferably configured such that the chirped fiber grating element (1) includes: (1) a first region in which a laser beam which has a lasing wavelength and has entered the chirped fiber grating element from the amplifying optical fiber propagates without being reflected; (2) a second region in which reflection of the laser beam which has the lasing wavelength and has entered the chirped fiber grating element from the amplifying optical fiber occurs; and (3) a third region in which a laser beam, which is remaining without being reflected in the second region among the laser beam which has the lasing wavelength and has entered the chirped fiber grating element from the amplifying optical fiber, propagates without being reflected, an average refractive index of high refractive index regions (11ai) included in the second region being lower than an average refractive index of all high refractive index regions (11ai).

The above configuration allows the chirped fiber grating element (1) to have a temperature lower than that of a general fiber Bragg grating element (in which each high refractive index region (11ai) has a refractive index equal to an average refractive index of all of the high refractive index regions (11ai) of the chirped fiber grating element (1)).

### [Supplemental Note]

The present invention is not limited to the embodiments, but can be altered by a skilled person in the art within the scope of the claims. The present invention also encompasses, in its technical scope, any embodiment derived by combining technical means disclosed in differing embodiments.

### Reference Signs List

1: chirped fiber grating element
1A, 1B: end surface
11: core
11a: grating
11ai: high refractive index region
12: clad

## Claims

1. A chirped fiber grating element comprising:
a core which has a refractive index of n0 and into which a grating consisting of high refractive index regions are written, each of the high refractive index regions having a refractive index of ni (ni > n0),
a pitch Λi of the grating increasing with increasing distance from one end surface of the chirped fiber grating element,
a refractive index difference Δni = ni-n0 of the grating increasing with increasing distance from the one end surface of the chirped fiber grating element.

2. The chirped fiber grating element as set forth in claim 1, wherein
the pitch Λi quadratically increases with increasing distance from the one end surface of the chirped fiber grating element.

3. The chirped fiber grating element as set forth in claim 2, wherein
the refractive index difference Δni linearly increases with increasing distance from the one end surface of the chirped fiber grating element.

4. A chirped fiber grating element comprising:
a core which has a refractive index of n0 and into which a grating consisting of high refractive index regions are written, each of the high refractive index regions having a refractive index of ni (ni > n0),
a pitch Λi of the grating increasing with increasing distance from one end surface of the chirped fiber grating element,
a thickness Di of the each of the high refractive index regions increasing with increasing distance from the one end surface of the chirped fiber grating element.

5. A fiber laser comprising:
an amplifying optical fiber; and
a chirped fiber grating element recited in any one of claims 1 through 4, the chirped fiber grating element being connected to one end or both ends of the amplifying optical fiber.

6. The fiber laser as set forth in claim 5, wherein
the chirped fiber grating element includes:
(1) a first region in which a laser beam which has a lasing wavelength and has entered the chirped fiber grating element from the amplifying optical fiber propagates without being reflected;
(2) a second region in which reflection of the laser beam which has the lasing wavelength and has entered the chirped fiber grating element from the amplifying optical fiber occurs; and
(3) a third region in which a laser beam, which is remaining without being reflected in the second region among the laser beam which has the lasing wavelength and has entered the chirped fiber grating element from the amplifying optical fiber, propagates without being reflected,
an average refractive index of high refractive index regions included in the second region being lower than an average refractive index of all high refractive index regions.
